# EUROPEAN PATENT APPLICATION

(11) **EP 2 975 919 A1**
(43) Date of publication of application: **20.01.2016**
(21) Application number: 14290202.2
(22) Date of filing: 14.07.2014
(51) Int. Cl.: H05K 7/20

(54) **A cabinet for housing electric and/or electronic components**

(71) Applicant: ALCATEL LUCENT, 92100 Boulogne-Billancourt (FR)
(72) Inventor: Pintelon, Johan, 2018 Antwerpen (BE)
(74) Representative: Plas, Axel Ivo Michel

(57) **Abstract**

A cabinet (100; 200) for housing electric/electronic components (110, 120) comprises:
- a first compartment (101; 201) housing components that require cooling in operation (110);
- a second compartment (102; 202) housing components that do not require cooling in operation (220); and
- a third compartment (103; 203) housing a heat exchanger (130) with an intake fan (131) extracting incoming air from the second compartment (102; 202) and a fan (133) injecting heat exchanger cooled air in the first compartment (101; 201).

The second compartment (102; 202) of the cabinet (100; 200) further comprises:
- a pollution filter free air intake opening (241) configured to allow an incoming external air stream (150; 250) to enter the second compartment (102; 202); and
- a hit plate (151; 251, 252) positioned and oriented in the second compartment (102; 202) and configured to cause the incoming external air stream (150; 250) to slow down and deposit pollution particles on the hit plate (151; 251, 252).

## Description

### Field of the Invention

The present invention generally relates to cabinets for electric and/or electronic components part of which are cooled through a heat exchanger. Examples of such cabinets are outside plant cabinets or street cabinets housing telecom equipment.

### Background

A typical outside plant cabinet that houses electric and/or electronic components part of which require cooling in operation has at least three compartments or spaces. In a first compartment, the components that require cooling in operation are housed. In a second compartment, components that do not require cooling but could require ventilation, such as for instance batteries, are housed. In a third compartment, a heat exchanger is housed. The heat exchanger typically comprises an intake fan that extracts incoming air at environmental temperature from the second compartment, cooling fins or tubes along which the incoming air is cooled, and a fan that injects the recirculated, internal, heat exchanger cooled air in the first compartment to cool the electric and/or electronic components housed therein.

It is common practice to put a dust filter in front of the heat exchanger, e.g. on the intake fan of the heat exchanger or at the inlet of the external airflow in a door or wall of the second compartment, in order to avoid that dust particles enter the heat exchanger and reduce the lifetime or performance of the heat exchanger. Such dust filter however has a limited capacity and therefore must be replaced regularly. Replacing the dust filter requires on-site maintenance personnel interventions that increase the operational expenses of the equipment housed in the cabinet. In situations where the dust filter is not replaced sufficiently frequent, the external airflow entering the cabinet shall reduce over time as a result of which cooling by the heat exchanger becomes less performant or heat exchanger noise increases. This may have a negative impact on the lifetime of the electric and/or electronic components that require cooling, or in a worst case scenario may even cause the equipment housed in the cabinet to fail as a result of overheated components.

### Summary of the Invention

Embodiments of the present invention disclose a cabinet that overcomes the above mentioned drawbacks of existing cabinets. The disclosure features a cabinet for housing electric and/or electronic components with reduced maintenance requirements and/or improved performance in the absence of regular maintenance.

According to some embodiments, there is provided a cabinet for housing electric and/or electronic components at least part of which require cooling in operation, as defined by claim 1, the cabinet comprising:
- a first compartment adapted to house a first set of components that require cooling in operation;
- a second compartment adapted to house a second set of components that do not require cooling in operation; and
- a third compartment adapted to house a heat exchanger with an intake fan configured to extract incoming air from the second compartment and a fan configured to inject heat exchanger cooled air in the first compartment,
   wherein the second compartment comprises:
- a pollution filter free air intake opening configured to allow an incoming external air stream to enter the second compartment; and
- a hit plate positioned and oriented in the second compartment, and configured to cause the incoming external air stream to slow down and deposit pollution particles on the hit plate.

Thus, embodiments of the invention reside in avoiding the use of dust filters that require regular maintenance or replacement. Instead, a plate is foreseen that introduces an abrupt change in the incoming external air stream as a result of which pollution particles are deposited on the plate. The hit plate hence serves as a pollution collection plate. Preferably it is placed perpendicular to the direction of the incoming external air stream, such that the incoming air almost comes to a stop at the plate. Further, the plate is preferably placed substantially parallel to the direction of the incoming air stream of the heat exchanger. The swirl, i.e. speed change and direction change, that is introduced by the hit plate allows to collect the biggest pollution particles on the plate. As a result of the grease and dust deposits on the hit plate, the hit plate preferably is cleaned from time to time. Cleaning the hit plate however is not mandatory and not cleaning the hit plate certainly does not impact the external air supply or performance of the heat exchanger. In summary, presence of the hit plate removes the necessity of a dust filter, reduces maintenance requirements and corresponding operational expenses, and reduces the risk of a malfunctioning heat exchanger and failing electronics as a result of inconsequent maintenance.

It is noticed that although the components housed in the second compartment of the cabinet in operation do not require cooling by the heat exchanger, these components may require ventilation or they may preferably operate in the presence of ventilation.

In a preferred embodiment of the cabinet for housing electric and/or electronic components, as defined by claim 2, the hit plate comprises:
- a vertical plane, oriented substantially perpendicular to a direction of flow of the incoming external air stream.

Indeed, the collection of pollution particles on the hit plate is optimal when the hit plate comprises a vertical or nearly-vertical plane that is directed substantially perpendicular, i.e. perpendicular with an acceptable deviation of +/- 20 %, to the incoming external air stream. In this case, the incoming air will come to a complete stop on or near the plate before it is drawn into the heat exchanger by the intake fan of the heat exchanger.

In an advantageous embodiment of the cabinet for housing electric and/or electronic components, defined by claim 3, the hit plate further comprises:
- a horizontal plane, oriented substantially parallel to a direction of flow of the incoming external air stream.

Indeed, the collection of pollution particles on the hit plate is further optimized in case a second, horizontal or nearly horizontal plane forms part of the hit plate. This horizontal plane prevents the incoming external air to travel upwards in the second compartment. Upward travelling air will be stopped at the horizontal plane which will serve as an additional plane for pollution particle deposits.

Optionally, as defined by claim 4, in the cabinet for housing electric and/or electronic components, the pollution filter free air intake opening is located in a door or wall of the second compartment, a lower border of the pollution filter free air intake opening being at a height above a lower border of the hit plate, and an upper border of the pollution filter free air intake opening being at a height below an upper border of the hit plate.

This way, the collection of pollution particles on the hit plate is further optimized since at least part of the incoming external air flow in the second compartment will be at a height where the hit plate is located. The remaining part of the incoming external air flow will be at a height below the hit plate. Since air will travel upward in the second compartment, this remaining part shall also hit the vertical and certainly the horizontal plane of the hit plate, causing pollution particles present therein to be deposited on the hit plate before the air enters the heat exchange.

Further optionally, as defined by claim 5, in the cabinet for housing electric and/or electronic components, the hit plate is accessibly and removable mounted in the second compartment.

Indeed, in order to simplify maintenance or cleaning of the hit plate, the hit plate preferably is removable from the second compartment, e.g. through screws. Advantageously, the hit plate is also made easily accessible, e.g. by mounting it at a visible location immediately behind the cabinet door. This way, maintenance time and operational costs of the cabinet are minimized.

According to yet another optional aspect of the cabinet for housing electric and/or electronic components, defined by claim 6, the second set of components comprises batteries and/or non-dust sensitive components.

This way, dislocation of pollution particles from the hit plate will only result in deposits on top of the batteries or non-dust sensitive components. Also, pollution particles that are not deposited on the hit plate may be deposited on top of the batteries or non-dust sensitive components as a result of the abrupt speed and direction changes that are introduced by the hit plate and heat exchanger intake fan. Such deposits do not hamper the operation of the batteries and/or non-dust sensitive components while it is avoided that such pollution particles enter the heat exchanger. Furthermore, placing batteries in the second compartment brings the additional advantage that toxic and/or explosive gasses produced by the batteries during charging/discharging are automatically drawn out of this second compartment through the intake fan of the heat exchanger. Compared to alternative implementations where batteries are located in a separate battery compartment, no additional active fans have to be provided in or near such battery compartment to suck the explosive gasses out of such battery compartment.

### Brief Description of the Drawings

Fig. 1 is a schematic front view of a first embodiment of the cabinet for housing electric and/or electronic components according to the present invention; and
Fig. 2 is a schematic three-dimensional view of a second embodiment of the cabinet for housing electric and/or electronic components according to the present invention.

### Detailed Description of Embodiment(s)

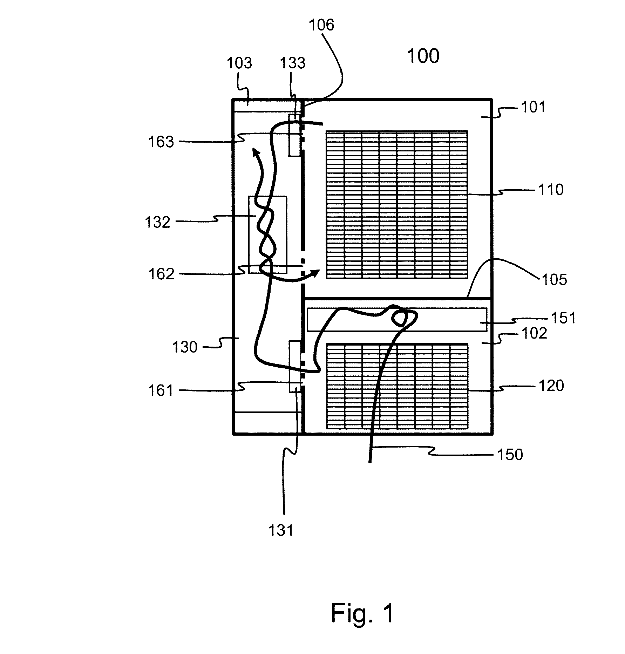

Fig. 1 is a front view of an outside plant cabinet 100 that holds electric and/or electronic components 110 that in operation require cooling and components 120 that in operation do not require cooling. The electric and/or electronic components 110 that require cooling are for instance line termination cards of an access multiplexer holding dedicated processors and/or analogue or digital application specific integrated circuits (ASICs) whose temperatures rise during operation. These electric and/or electronic components 110 are housed in a first compartment 101 of the cabinet 100 that will be cooled. The other possible electric and/or electronic components 120 that do not require cooling are housed in a second compartment 102 of the cabinet 100. The electric and/or electronic components 120 that do not require cooling are for instance batteries. A third compartment 103 of the outside plant cabinet 100 contains a heat exchanger 130 that extracts air from the second compartment 102 through an intake fan 131 which cools by exchanging heat the other, internal airflow along cooling pipes or fins 132. The heat exchanger cooled airflow is injected through an additional fan 133 in the first compartment 101 to cool the electric and/or electronic components 110 that require cooling. The first compartment 101 and second compartment 102 are separated through an internal cabinet wall 105. The third compartment 103 is separated from the first and second compartments 101 and 102 through another internal cabinet wall 106. The latter cabinet wall 106 has the necessary openings or perforations to enable the intake fan 131 of the heat exchanger 130 to suck air from the second compartment 102 and to enable the fan 133 of the heat exchanger 130 to inject heat exchanger cooled air in the first compartment 101. Fig. 1 for instance shows perforations 161, 162 and 163, respectively in the wall 106 between the third compartment 103 and first compartment 101 and between the third compartment 103 and second compartment 102, through which the intake air and heat exchanger cooled air are moved.

The outside plant cabinet 100 drawn in Fig. 1 further is equipped with a hit plate 151 in the second compartment 102. The hit plate consists of a vertical plane 151 mounted in the second compartment 102 nearly perpendicular to the external air flow 150 that is supposed to enter the second compartment 102 of the cabinet 100. The hit plate 151 abruptly reduces the speed of the external air flow 150 that enters the second compartment. As a consequence, the air will almost come to a stop and swirl in the vicinity of the hit plate 151. This is illustrated by arrow 150 in Fig. 1. Pollution particles present in the external airflow will be deposited on the hit plate 151 as a result of the abrupt change in speed and direction. Thereafter, the external air will be drawn towards the heat exchanger 130 by intake fan 131. The airflow that enters the heat exchanger shall almost be free of pollution particles. In particular the biggest pollution particles, i.e. grease and dust particles, will have been deposited on the hit plate 151 and no longer enter the heat exchanger 130. The lifetime of the heat exchanger is increased significantly without requiring dust filters that involve regular maintenance or replacement. The hit plate 151 that serves as swirl based air filter preferably is cleaned from time to time in the field to remove dust and grease depositions. Cleaning the hit plate 151 however is not mandatory and not cleaning the hit plate 151 does not impact the air supply towards to heat exchanger and consequently also not the cooling performance of the heat exchanger. In case of dust filters, irregular cleaning or replacing a dust filter will lead to reduced air supply for the heat exchanger and consequently to reduced cooling performance of the heat exchanger which may in turn result in failing electric or electronic components 110.

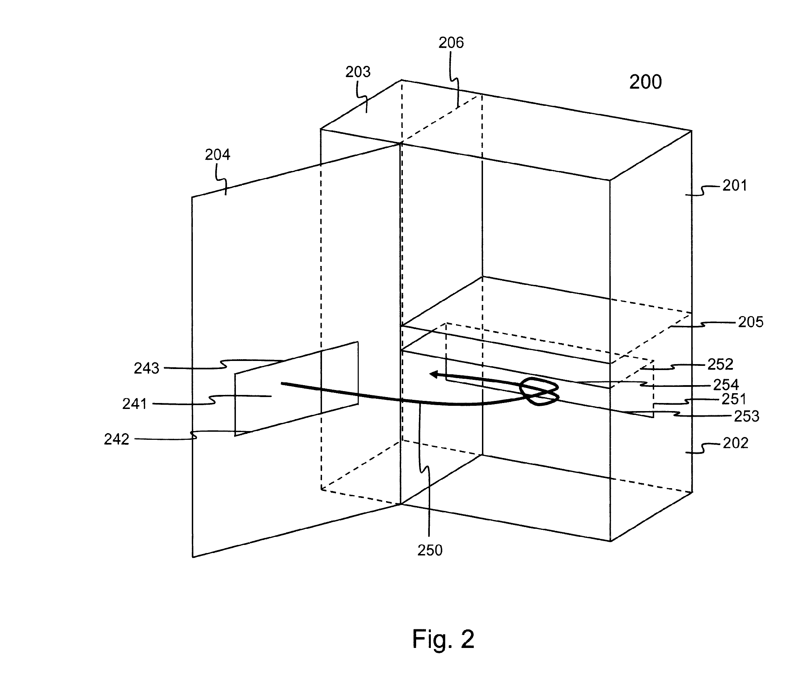

Fig. 2 shows a second embodiment 200 of an outside plant cabinet or street cabinet that houses sensitive, active electric or electronic components that require cooling in a first compartment 201, non-dust sensitive electric or electronic components in a second compartment 201, and a heat exchanger in a third compartment. The cabinet 200 has internal walls 205 and 206 separating the first compartment 201, second compartment 202 and third compartment 203. The street cabinet 200 drawn in Fig. 2 further is equipped with a hinging door 204 having an opening 241 through which an external airflow 250 enters the second compartment 202. In the second compartment 202, the external airflow 250 is abruptly changed in speed and direction on or near a hit plate that has a vertical plane 251 and a horizontal plane 252. This is illustrated by arrow 250 in Fig. 2. In comparison with the first embodiment 100, the horizontal plane 252 of the hit plate in the second embodiment 200 brings the advantage that the external airflow 250 is prevented to rise in the cabinet 200 and additional pollution particles will be deposited on the bottom surface, i.e. the surface facing downward, of the horizontal plane 252 of the hit plate. Just like in the first embodiment 100, no dust filter is needed in the external air intake opening 241 of the second embodiment 200 while the airflow that enters the heat exchanger in the third compartment 203 may be assumed to be nearly free of pollution particles. These pollution particles, in particular the biggest ones, will have been deposited onto the hit plate 251 and 252 as a result of the abrupt changes in speed and direction introduced by the hit plate 251, 252 and the heat exchanger, present in the embodiment of Fig. 2 but not drawn, with intake fan to draw air from the second compartment 202 and fan for injecting heat exchanger cooled air in the first compartment 201.

Preferably, the lower border 242 of the air intake opening 241 in cabinet door 204 has a height above the lower border 253 of the vertical plane 251 of the hit plate and the upper border 243 of the air intake opening 241 has a height below the height or edge 254 of the horizontal plane 252 of the hit plate. This way, pollution particle deposit on the hit plate is maximized.

In case the non-dust sensitive electric or electronic components located in the second compartment of the cabinet contain batteries, embodiments of the present invention bring the advantage that toxic and/or explosive gasses produced by these batteries are automatically drawn away from the second compartment by the intake fan of the heat exchanger. Hence, no additional fans need to be foreseen to that extent.

Although the present invention has been illustrated by reference to specific embodiments, it will be apparent to those skilled in the art that the invention is not limited to the details of the foregoing illustrative embodiments, and that the present invention may be embodied with various changes and modifications without departing from the scope thereof. The present embodiments are therefore to be considered in all respects as illustrative and not restrictive, the scope of the invention being defined by the appended claims rather than by the foregoing description, and all changes which come within the meaning and range of equivalency of the claims are therefore intended to be embraced therein. In other words, it is contemplated to cover any and all modifications, variations or equivalents that fall within the scope of the basic underlying principles and whose essential attributes are claimed in this patent application. It will furthermore be understood by the reader of this patent application that the words "comprising" or "comprise" do not exclude other elements or steps, and that the words "a" or "an" do not exclude a plurality. Any reference signs in the claims shall not be construed as limiting the respective claims concerned. The terms "first", "second", third", "a", "b", "c", and the like, when used in the description or in the claims are introduced to distinguish between similar elements or steps and are not necessarily describing a sequential or chronological order. It is to be understood that the terms so used are interchangeable under appropriate circumstances and embodiments of the invention are capable of operating according to the present invention in other sequences, or in orientations different from the one(s) described or illustrated above.

## Claims

1. A cabinet (100; 200) for housing electric and/or electronic components (110, 120) at least part of which require cooling in operation, said cabinet (100; 200) comprising:
- a first compartment (101; 201) adapted to house a first set of said components that require cooling in operation (110);
- a second compartment (102; 202) adapted to house a second set of said components that do not require cooling in operation (220); and
- a third compartment (103; 203) adapted to house a heat exchanger (130) with an intake fan (131) configured to extract incoming air from said second compartment (102; 202) and a fan (133) configured to inject heat exchanger cooled air in said first compartment (101; 201),
wherein said second compartment (102; 202) comprises:
- a pollution filter free air intake opening (241) configured to allow an incoming external air stream (150; 250) to enter said second compartment (102; 202); and
- a hit plate (151; 251, 252) positioned and oriented in said second compartment (102; 202), and configured to cause said incoming external air stream (150; 250) to slow down and deposit pollution particles on said hit plate (151; 251, 252).

2. A cabinet (100; 200) for housing electric and/or electronic components (110, 120) according to claim 1, wherein said hit plate (151; 251, 252) comprises:
- a vertical plane (151; 251), oriented substantially perpendicular to a direction of flow of said incoming external air stream (150; 250).

3. A cabinet (200) for housing electric and/or electronic components according to claim 1, wherein said hit plate (251, 252) comprises:
- a horizontal plane (252), oriented substantially parallel to a direction of flow of said incoming external air stream (250).

4. A cabinet (100; 200) for housing electric and/or electronic components (110, 120) according to claim 1, wherein said pollution filter free air intake opening (241) is located in a door (204) or wall of said second compartment (102; 202), a lower border (242) of said pollution filter free air intake opening (241) being at a height above a lower border (253) of said hit plate (151; 251, 252) and an upper border (243) of said pollution filter free air intake opening (241) being at a height below an upper border (254) of said hit plate (151; 251, 252).

5. A cabinet (100; 200) for housing electric and/or electronic components (110, 120) according to claim 1, wherein said hit plate (151; 251, 252) is accessibly and removable mounted in said second compartment (102; 202).

6. A cabinet (100; 200) for housing electric and/or electronic components (110, 120) according to claim 1, wherein said second set of said components (120) comprises batteries and/or non-dust sensitive components.
